(19)

Europäisches
Patentamt
European
Patent Office
Office européen
des brevets

(11)    **EP 4 398 011 A1**

(12)    **EUROPEAN PATENT APPLICATION**
published in accordance with Art. 153(4) EPC

(43) Date of publication:
**10.07.2024   Bulletin 2024/28**

(51) International Patent Classification (IPC):
***G02B 6/136*** *(2006.01)*     ***G06N 10/80*** *(2022.01)*

(21) Application number: **23825938.6**

(22) Date of filing: **25.04.2023**

(52) Cooperative Patent Classification (CPC):
**G02B 6/136; G06F 30/27; G06N 10/20;
G06N 10/40; G06N 10/80**

(86) International application number:
**PCT/CN2023/090539**

(87) International publication number:
**WO 2023/246285 (28.12.2023 Gazette 2023/52)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority:  **22.06.2022  CN 202210713974**

(71) Applicant: **Tencent Technology (Shenzhen)
Company Limited
Shenzhen, Guangdong, 518057 (CN)**

(72) Inventors:
• **LI, Dengfeng
  Shenzhen, Guangdong 518057 (CN)**

• **ZHANG, Wenlong
  Shenzhen, Guangdong 518057 (CN)**
• **DAI, Maochun
  Shenzhen, Guangdong 518057 (CN)**
• **BU, Kunliang
  Shenzhen, Guangdong 518057 (CN)**
• **HUAI, Sainan
  Shenzhen, Guangdong 518057 (CN)**

(74) Representative: **Gunzelmann, Rainer
Wuesthoff & Wuesthoff
Patentanwälte und Rechtsanwalt PartG mbB
Schweigerstraße 2
81541 München (DE)**

(54)    **METHOD AND APPARATUS FOR PREPARING QUANTUM CHIP, AND ELECTRONIC DEVICE,
COMPUTER-READABLE STORAGE MEDIUM, COMPUTER PROGRAM PRODUCT AND
QUANTUM CHIP**

(57)    Provided in the present application are a method and apparatus for preparing a quantum chip, and an electronic device, a computer-readable storage medium, a computer program product and a quantum chip. The method comprises: determining an initial intrinsic frequency of a chip substrate; on the basis of a comparison result between the value of the initial intrinsic frequency and the value of a quantum working frequency, performing pattern etching treatment on a first surface of the chip substrate, so as to obtain a chip substrate which has a complete second surface and has a target pattern on the first surface, wherein the quantum working frequency is the working frequency of quantum bits of a quantum circuit, the second surface is opposite the first surface, and the target pattern is a pattern when the difference value between the intrinsic frequency of the chip substrate and the quantum working frequency is the maximum; and etching the second surface of the chip substrate which

has been subjected to the pattern etching treatment,, so as to form the quantum circuit, thereby forming a quantum chip.

FIG. 3A

**Description**

RELATED APPLICATION

This application is based on and claims priority to Chinese Patent Application No.202210713974.9 with an application date of June 22, 2022.

FIELD OF THE TECHNOLOGY

This application relates to chip processing technology, and in particular to, a preparation method and apparatus for a quantum chip, an electronic device, a computer-readable storage medium, a computer program product, and a quantum chip.

BACKGROUND OF THE DISCLOSURE

Because quantum computing is based on the principle of superposition state, quantum computing has much greater computational power than traditional computers on specific issues, which has aroused great interest in academia and industry. The computational power of quantum computing depends mainly on relaxation time and scalability. In order to achieve good scalability, superconducting materials are usually chosen to prepare nonlinear circuits on the substrate to construct quantum bits; and the important factor affecting the relaxation time of the quantum bit is the substrate eigenmode of the chip.

The effect of the substrate eigenmode on the coherence of quantum bits leads to a short relaxation time, thus limiting the computational power of quantum computing, for which there is no effective solution in the related art.

SUMMARY

The embodiments of this application provide a preparation method and apparatus for a quantum chip, an electronic device, a computer-readable storage medium, a computer program product, and a quantum chip, which can reduce the influence of an eigenfrequency of a chip substrate on the coherence of a quantum bit, prolong the coherence time of the quantum chip, and increase the computing capability of the quantum chip.

The technical solutions of the embodiments of this application are implemented as follows:

The embodiments of this application provide a preparation method for a quantum chip, including:

determining an initial eigenfrequency of a chip substrate;

performing, based on a numerical comparison result between the initial eigenfrequency and a quantum operating frequency, pattern etching on a first surface of the chip substrate to obtain a chip substrate with an intact second surface and the first surface with a target pattern;

the quantum operating frequency being an operating frequency of a quantum bit of a quantum circuit, the second surface being opposite to the first surface, and the target pattern being a pattern when a difference between the eigenfrequency of the chip substrate and the quantum operating frequency is maximum; and

etching, on the second surface of the pattern-etched chip substrate, the quantum circuit to form the quantum chip.

The embodiments of this application provide a preparation apparatus for a quantum chip, including:

a determination module, configured to determine an initial eigenfrequency of a chip substrate;

an etching module, configured to perform, based on a numerical comparison result between the initial eigenfrequency and a quantum operating frequency, pattern etching on a first surface of the chip substrate to obtain a chip substrate with an intact second surface and the first surface with a target pattern;

the quantum operating frequency being an operating frequency of a quantum bit of a quantum circuit, the second surface being opposite to the first surface, and the target pattern being a pattern when a difference between the eigenfrequency of the chip substrate and the quantum operating frequency is maximum; and

a preparation module, configured to etch, on the second surface of the pattern-etched chip substrate, the quantum circuit to form the quantum chip.

The embodiments of this application provide a quantum chip, a chip substrate of the quantum chip including an opposing first surface and second surface;

the first surface having a target pattern, the target pattern being a pattern when a difference between an eigenfrequency of the chip substrate and a quantum operating frequency is maximum; and

the second surface being provided with a quantum circuit, an operating frequency of a quantum bit of the quantum circuit being the quantum operating frequency.

The embodiments of this application provide an electronic device, including:

a memory, configured to store computer-executable instructions; and

a processor, configured to implement, in executing the computer-executable instructions stored in the memory, the preparation method for a quantum chip provided by the embodiments of this application.

The embodiments of this application provide a computer-readable storage medium storing computer-executable instructions for implementing the preparation method for a quantum chip provided by the embodiments of this application during being executed by a processor.

The embodiments of this application provide a computer program product including computer-executable instructions, the computer-executable instructions, when executed by a processor, implementing the preparation method for a quantum chip provided by the embodiments of this application.

The embodiments of this application have the following beneficial effects.

Pattern etching is performed on a first surface of the chip substrate based on a numerical comparison result between the initial eigenfrequency and a quantum operating frequency to obtain a chip substrate with an intact second surface and the first surface with a target pattern; since the target pattern is a pattern when a difference between the eigenfrequency of the chip substrate and the quantum operating frequency is maximum, the effect of the eigenfrequency of the chip substrate on the coherence of the quantum bit can be eliminated, thereby increasing the computing capability of the quantum chip. The quantum circuit is etched on the second surface of the pattern-etched chip substrate, to form the quantum chip; since the pattern is etched on the first surface of the chip substrate, the morphology and size of the second surface of the chip substrate are not affected, so that the quantum circuit can be normally prepared.

BRIEF DESCRIPTION OF THE DRAWINGS

FIG. 1 is a structural diagram of a preparation system of a quantum chip provided by an embodiment of this application.

FIG. 2 is a structural diagram of an electronic device provided by an embodiment of this application.

FIGs. 3A-3B are flow diagrams of a preparation method for a quantum chip provided by an embodiment of this application.

FIG. 4 is a flow diagram of a preparation method for a quantum chip provided by an embodiment of this application.

FIG. 5 is a cutting diagram of a preparation method for a quantum chip provided by an embodiment of this application.

FIG. 6 is a cutting diagram of a preparation method for a quantum chip provided by an embodiment of this application.

FIG. 7 is a diagram of changes in an eigenfrequency of a preparation method for a quantum chip provided by an embodiment of this application.

FIG. 8 is a cutting diagram of a preparation method for a quantum chip provided by an embodiment of this application.

FIG. 9 is a cutting diagram of a preparation method for a quantum chip provided by an embodiment of this application.

FIG. 10 is a diagram of changes in an eigenfrequency of a preparation method for a quantum chip provided by an embodiment of this application.

DESCRIPTION OF EMBODIMENTS

To make the objectives, technical solutions, and advantages of this application clearer, the following describes this application in further detail with reference to the accompanying drawings. The described embodiments are not to be considered as a limitation to this application. All other embodiments obtained by a person of ordinary skill in the art without creative efforts shall fall within the protection scope of this application.

In the following description, the term "some embodiments" describes subsets of all possible embodiments, but it may be understood that "some embodiments" may be the same subset or different subsets of all the possible embodiments, and can be combined with each other without conflict.

In the following description, the terms "first, second, and third" are merely intended to distinguish similar objects and do not represent a particular ordering of objects. It may be understood that the terms "first, second, and third" may be interchanged either in a particular order or in a sequential order, as permitted, to enable the embodiments of this application described herein to be implemented other than that illustrated or described herein.

Unless otherwise defined, meanings of all technical and scientific terms used in this specification are the same as those usually understood by a person skilled in the art to which this application belongs. The terms used herein describe the embodiments of this application only and are not intended to limit this application.

Before the embodiments of this application are further described in detail, a description is made on nouns and terms in the embodiments of this application, and the nouns and terms in the embodiments of this application are applicable to the following explanations.

(1) Chip substrate eigenmodes refer that the standing wave field formed along the longitudinal direction of the axis satisfies the resonant condition. Since the chip substrate is usually square, it is equivalent to forming a two-dimensional resonant cavity in the microwave band on the chip substrate, and thus has its own eigenmodes.

(2) Quantum computing is a new computing mode following the law of quantum mechanics to control the quantum information unit. Compared with the traditional general-purpose computer, its theoretical model is a general-purpose Turing machine. The theoretical model of a general-purpose quantum computer is a general-purpose Turing machine re-interpreted by the law of quantum mechanics.

(3) Quantum circuits are a collection of quantum gates connected non-cyclically via input-output lines. The size and depth of the quantum circuits are the number of nodes and the depth of the bottom connection graph, respectively.

(4) Quantum chips are chips obtained by integrating the quantum circuits on the substrate, further carrying the function of quantum information processing.

(5) A quantum superposition state refers that the superposition state of different quantum states of the quantum system is obtained by normalizing and linearly combining a plurality of quantum states of the quantum system.

(6) Relaxation time is the time required for quantum bits (a form of carrying quantum information) to degenerate from a quantum superposition state to a classical state.

(7) A relaxation rate is the rate at which the quantum bits degenerate from the quantum superposition state to the classical state.

Traditional computers can only manipulate a deterministic state of one bit at a time, while quantum computing can manipulate the superposition state using the principle of state superposition, so the computational power is greatly improved. However, the superposition state based on quantum mechanics is easily disturbed by the environment to depolarize to the classical state; the time of depolarization is called relaxation time, and the length of relaxation time directly affects the computational power of the quantum computer. In addition to relaxation time, scalability is also an important index affecting quantum computing, which directly determines the number of computer bits. Superconductivity-based quantum computing schemes may achieve good scalability. Usually, superconducting materials such as aluminum and tantalum are used to prepare nonlinear inductance circuits on silicon wafers or sapphire substrates to construct quantum bits.

The factors affecting the relaxation time of the quantum bits, in this case, are the eigenmodes of the substrate in addition to the losses due to the materials and the substrate. Since the substrate is generally square, there is also a standing wave of electromagnetic waves inside the substrate, which may form an eigenmode of the substrate. Superconducting quantum bits typically operate at frequencies from 4 gigahertz to 6 gigahertz. Quantum chips are often prepared using 8 millimeters by 8 millimeters silicon substrates with an eigenfrequency of 7.7 gigahertz; and the eigenfrequency of sapphire substrates of 8 millimeters by 8 millimeters is about 8.4 gigahertz. This is relatively close to the operating frequency of the quantum bit. As the number of bits on the chip increases, the size of the chip needs to be increased, for example, using 10 millimeters by 10 millimeters silicon and sapphire chips. In this case, the eigenfrequency of the silicon chip of 10 millimeters by 10 millimeters is 6.1 gigahertz; the eigenfrequency of the sapphire substrate of 10 millimeters by 10 millimeters is 6.7 gigahertz, and the chip eigenfrequency and the quantum bit operating frequency are closer.

In implementing the embodiments of this application, the applicant has found that, for a quantum chip of a superconducting material, the relaxation rate induced by a substrate mode may be seen in formula (1):

$$\Gamma = (\frac{g}{\Delta})^2 \kappa \qquad\qquad (1)$$

g represents the coupling strength of the quantum bit and the chip substrate mode; $\Delta$ represents the frequency difference between the operating frequency of the quantum bit and the eigenfrequency of the substrate; and $\kappa$ represents the attenuation rate of the electromagnetic field mode around the quantum bit.

It may be seen from formula (1) that when the eigenfrequency of the substrate and the operating frequency of the quantum bit are relatively close, that is, $\Delta$ is small, the relaxation rate of the quantum bit caused by the substrate mode is fast, which significantly affects the coherence of the quantum bit. Therefore, an important way to improve the coherence of the quantum bit is to enlarge the difference between the eigenfrequency of the substrate and the operating frequency of the quantum bit.

For a silicon substrate, the related art uses a deep silicon etching process to etch a periodic through-hole on the silicon substrate; and when the period of the small hole is less than the wavelength of an electromagnetic wave, the existence of the small hole may significantly suppress the eigenmode of the chip substrate. Sapphire substrates are more widely used in quantum chips due to lower loss than silicon substrates. For sapphire, there is currently no mature through-hole process.

For the sapphire substrate, in the related art, the size of the sapphire is changed. Since the operating frequency of the quantum chip is lower than the eigenfrequency of the sapphire substrate, the size of the sapphire substrate may be reduced to move the eigenfrequency of the substrate to a high frequency. For example, when the operating frequency of the quantum chip is 5 gigahertz and the size of the substrate is 10 millimeters by 10 millimeters, the eigenfrequency thereof is 6.7 gigahertz, and $\Delta$ is 1.7 gigahertz. When a substrate of 8 millimeters by 8 millimeters is chosen, the eigenfrequency is 8.4 gigahertz, and $\Delta$ is 3.4 gigahertz. A chip size of 6 millimeters by 6 millimeters may be chosen with an eigenfrequency of 11.2 gigahertz, and $\Delta$ is 6.5 gigahertz. It may be seen that reducing the substrate size can significantly pull the distance between the eigenfrequency of the chip substrate and the operating frequency of the quantum bit away. However, the method may only be used when the number of the quantum bits is small, for example, only a few quantum bits. As the number of quantum bits increases, for example, hundreds of quantum bits, the substrate size cannot be easily changed due to the dramatic increase in circuitry on the chip necessitating the use of large-sized substrates.

In summary, the effect of the substrate eigenmode on the coherence of quantum bits leads to a short relaxation time, thus limiting the computational power of quantum computing, for which there is no effective solution in the related art.

The embodiments of this application provide a preparation method and apparatus for a quantum chip, an electronic device, a computer-readable storage medium, a computer program product, and a quantum chip, which can reduce the influence of an eigenfrequency of a chip substrate on the coherence of a quantum bit, prolong the coherence time of the quantum chip, and increase the computing capability of the quantum chip.

An exemplary application of the electronic device provided by the embodiments of this application is described below. The electronic device provided by the embodiments of this application may be implemented as various types of user terminals such as a laptop, a tablet, a desktop computer, a set-top box, and a mobile device (for example, a mobile phone, a portable music player, a personal digital assistant, a dedicated messaging device, and a portable gaming device), and may also be implemented as servers. In the following, an exemplary application when the device is implemented as a server will be described.

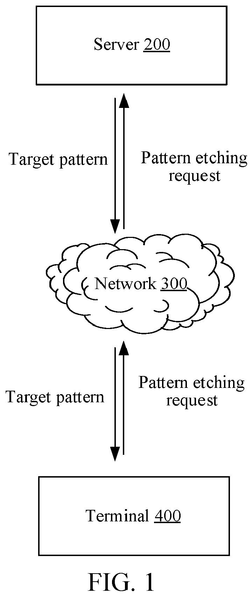

Referring to FIG. 1, FIG. 1 is a structural diagram of a preparation system of a quantum chip provided by an embodiment of this application. A terminal 400 is connected to a server 200 via a network 300; the network 300 may be a wide area network or a local area network, or a combination of both.

In some embodiments, the preparation method for a quantum chip provided in the embodiments of this application may be implemented by a terminal cooperating with a server; the server 200 determines an initial eigenfrequency of a chip substrate; the server 200 compares the initial eigenfrequency of the chip substrate with a quantum operating frequency (which generally refers to a frequency at which a quantum bit or a quantum gate in the quantum circuit is operated in the quantum computing); the server 200 determines a target pattern based on a numerical comparison result; the target pattern is sent to the terminal 400; the terminal 400 performs pattern etching on a first surface of the chip substrate to obtain a chip substrate with an intact second surface and the first surface with the target pattern. The quantum operating frequency is an operating frequency of a quantum bit of the quantum circuit; the second surface is opposite to the first surface; the target pattern is a pattern when the difference between the eigenfrequency of the chip substrate and the quantum operating frequency is maximum. The terminal 400 etches the quantum circuit on the second surface of the pattern-etched chip substrate to form a quantum chip.

In some embodiments, the preparation method for a quantum chip provided in the embodiments of this application may also be implemented by a terminal or a server alone, taking the terminal alone implementation as an example. The terminal 400 determines an initial eigenfrequency of a chip substrate; the terminal 400 compares the initial eigenfrequency of the chip substrate with a quantum operating frequency; the terminal 400 determines a target pattern based on a numerical comparison result; the target pattern is sent to the terminal 400; the terminal 400 performs pattern etching on a first surface of the chip substrate to obtain a chip substrate with an intact second surface and the first surface with the target pattern. The quantum operating frequency is an operating frequency of a quantum bit of the quantum circuit; the second surface is opposite to the first surface; the target pattern is a pattern when the difference between the eigenfrequency of the chip substrate and the quantum operating frequency is maximum. The terminal 400 etches the quantum circuit on the second surface of the pattern-etched chip substrate to form a quantum chip.

In some embodiments, the server 200 may be an independent physical server, and may also be a server cluster or distributed system composed of a plurality of physical servers, and may further be a cloud server providing basic cloud computing services such as cloud services, cloud databases, cloud computing, cloud functions, cloud storage, network services, cloud communications, middleware services, domain name services, security services, content delivery network (CDN), as well as big data and artificial intelligence platforms. The terminal 400 may be, but is not limited to, a smartphone, a tablet, a laptop, a desktop computer, a smart speaker, a smartwatch, a smart voice interaction device, a smart home appliance, a vehicle terminal, an aircraft, and the like. The terminal and the server may be directly or indirectly connected through wired or wireless communication, which is not limited to the embodiments of this application.

In some embodiments, the terminal or the server may implement the preparation method for a quantum chip provided by the embodiments of this application by running a computer program. For example, the computer program may be a native program or a software module in an operating system. It may be a local application (APP), namely, a program that needs to be installed in the operating system to run, such as a maintenance APP of an industrial device. It may be an applet, namely, a program that only needs to be downloaded to the browser environment to run. In general, the above computer programs may be any form of APP, module, or plug-in.

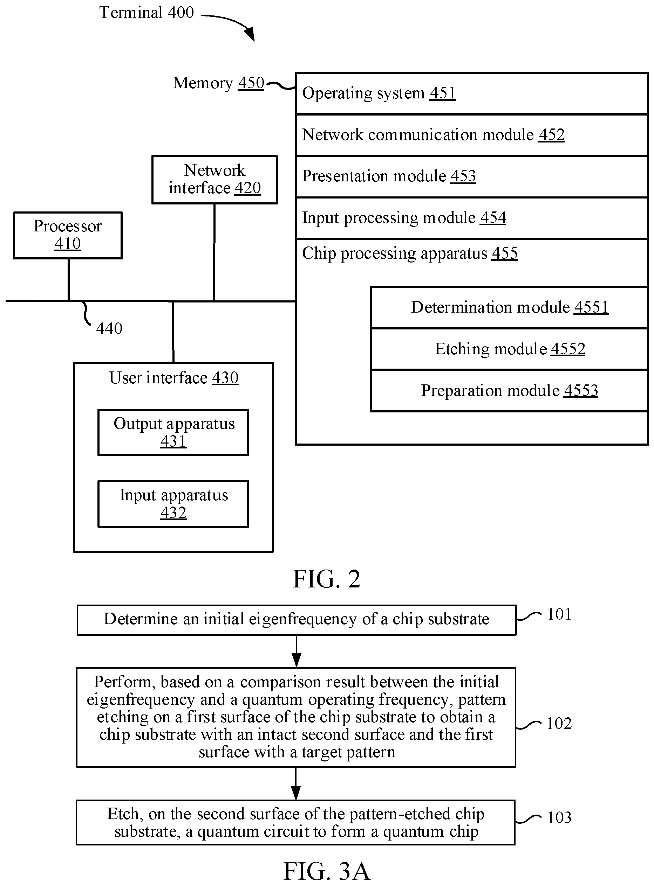

Referring to FIG. 2, FIG. 2 is a structural diagram of an electronic device provided by an embodiment of this application. The terminal 400 shown in FIG. 2 includes at least one processor 410, a memory 450, at least one network interface 420, and a user interface 430. The various assemblies in the terminal 400 are coupled together by a bus system 440. It may be understood that the bus system 440 is configured to implement connection and communication between the components. The bus system 440 includes a power bus, a control bus, and a status signal bus in addition to a data bus. However, for the sake of clarity, the various buses are labeled as the bus system 440 in FIG. 2.

The processor 410 may be an integrated circuit chip with signal processing capabilities, such as a general-purpose processor, a digital signal processor (DSP), or other programmable logic devices, discrete gate or transistor logic devices, and discrete hardware assemblies; the general-purpose processor may be a microprocessor or any conventional processor, and the like.

The user interface 430 includes one or more output apparatuses 431 enabling the presentation of media content, including one or more speakers and/or one or more visual display screens. The user interface 430 further includes one or more input apparatuses 432, including user interface components that facilitate user input, such as a keyboard, mouse, microphone, touch-screen display screen, camera, other input buttons, and controls.

The memory 450 may be removable, non-removable, or a combination thereof. Exemplary hardware devices include solid-state memories, hard disk drives, optical disk drives, and the like. The memory 450 may include one or more storage devices physically located remotely from the processor 410.

The memory 450 includes a volatile memory or a non-volatile memory, and may include both volatile and non-volatile memories. The non-volatile memory may be a read-only memory (ROM), and the volatile memory may be a random-access memory (RAM). The memory 450 described in the embodiments of this application is intended to include any suitable type of memory.

In some embodiments, the memory 450 can store data to support various operations; the examples of the data include programs, modules, and data structures, or subsets or supersets thereof, as exemplified below.

An operating system 451 is configured to implement various basic services and processing hardware-based tasks, including system programs for processing various basic system services as well as executing hardware-related tasks, such as a framework layer, a core library layer, and a driver layer.

A network communication module 452 is configured to reach other electronic devices via one or more (wired or wireless) network interfaces 420, an exemplary network interface 420 including Bluetooth, WiFi, a universal serial bus (USB), and the like.

A presentation module 453 is configured to enable the presentation of information (for example, a user interface for operating peripheral devices and displaying content and information) via one or more output apparatuses 431 (for example, a display screen and a speaker) associated with the user interface 430.

An input processing module 454 is configured to detect one or more user inputs or interactions from one of the one or more input apparatuses 432 and interpret the detected inputs or interactions.

In some embodiments, an apparatus provided by an embodiment of this application may be implemented in software. FIG. 2 shows a preparation apparatus 455 stored in a quantum chip of a memory 450, which may be software in the form of a program, a plug-in, and the like, including the following software modules: a determination module 4551, an etching module 4552, and a preparation module 4553, which are logical and therefore may be arbitrarily combined or further split depending on the function implemented. The functions of the various modules will be described below.

The preparation method for a quantum chip provided by the embodiments of this application will be described in conjunction with an exemplary application and implementation of the terminal provided by the embodiments of this application. The steps performed by the terminal may be performed by a client running on the terminal; and for the convenience of expression, this application does not specifically distinguish the terminal from the client running on the terminal. It should be further noted that the preparation method for a quantum chip provided by the embodiments of this application may be performed by various forms of computer programs running on the terminal, and is not limited to the above client running on the terminal, but may also be an operating system, a software module, a script, and an applet as described above.

Referring to FIG. 3A, FIG. 3A is a flow diagram of a preparation method for a quantum chip provided by an embodiment of this application, which will be illustrated in combination with steps 101 to 103 shown in FIG. 3A.

Step 101: Determine an initial eigenfrequency of a chip substrate.

In some embodiments, the determining an initial eigenfrequency of a chip substrate in step 101 may be implemented by the following technical solutions: acquiring a length and width of the first surface when the first surface of the chip substrate is a rectangle, for example, when the first surface is a rectangle, acquiring the length and width of the rectangle; and determining an initial eigenfrequency of the chip substrate based on the length and width of the first surface. Since the thickness of the chip substrate is much smaller than the length and width of the chip substrate, the chip substrate may be considered as a two-dimensional resonant cavity to calculate the initial eigenfrequency. The computing efficiency of the initial eigenfrequency may be improved by considering the chip substrate as a two-dimensional resonant cavity to calculate the initial eigenfrequency (i.e., a resonant frequency of the two-dimensional resonant cavity at the intrinsic mode) according to the embodiments of this application.

In some embodiments, the determining an initial eigenfrequency of the chip substrate based on the length and width of the first surface may be implemented by the following technical solutions: squaring the length to obtain a first square result, and squaring the width to obtain a second square result; determining a first ratio of a square result of a circumference rate constant to the first square result, and a second ratio of the square result of the circumference rate constant to the second square result; extracting a sum result of the first ratio and the second ratio to obtain an extraction result; and taking a ratio of the extraction result to a substrate constant as the initial eigenfrequency, the substrate constant being obtained based on permeability of the chip substrate and a dielectric constant of the chip substrate. The initial eigenfrequency may be calculated by considering the chip substrate as a two-dimensional resonant cavity according to the embodiments of this application, so that the initial eigenfrequency may be accurately and efficiently determined.

As an example, when the chip substrate is regarded as a two-dimensional resonant cavity to calculate the initial eigenfrequency, the calculation of the initial eigenfrequency may be seen in formula (2):

$$f = \frac{1}{2\pi\sqrt{\mu\varepsilon}}\sqrt{(\frac{\pi}{l})^2 + (\frac{\pi}{w})^2} \qquad (2)$$

$\mu$ and $\varepsilon$ are the permeability and dielectric constant, respectively, of the chip substrate; l and w are the length and width, respectively, of the chip substrate; f is the initial eigenfrequency; the substrate constant is $2\pi\sqrt{\mu\varepsilon}$; and $\pi$ is the circumference rate constant.

Step 102: Perform, based on a numerical comparison result between the initial eigenfrequency and a quantum operating frequency, pattern etching on a first surface of the chip substrate to obtain a chip substrate with an intact second surface and the first surface with a target pattern.

As an example, the quantum operating frequency is an operating frequency of a quantum bit of a quantum circuit (the quantum bit may be understood as an element in the quantum circuit, and the quantum operating frequency is an operating frequency of such element), the second surface is opposite to the first surface, and the target pattern is a pattern when a difference between the eigenfrequency of the chip substrate and the quantum operating frequency is maximum.

As an example, a substrate etching manner is determined according to a numerical comparison result that the quantum operating frequency is less than the quantum operating frequency or not less than the quantum operating frequency, specifically, an etched target pattern is determined; and pattern etching is performed on a first surface of the chip substrate based on the target pattern to obtain a chip substrate with an intact second surface and the first surface with a target pattern. When the quantum operating frequency is less than the eigenfrequency of the chip substrate, the target pattern is to be etched to shift the eigenfrequency of the chip substrate to a high frequency, that is, acquiring the target pattern of the first surface in response to the eigenfrequency of the chip substrate being maximum. When the quantum operating frequency is not less than the eigenfrequency of the chip substrate, the target pattern is to be etched to shift the eigenfrequency of the chip substrate to a low frequency, namely, acquiring the target pattern of the first surface in response to the eigenfrequency of the chip substrate being minimum.

As an example, the initial chip substrate is a cube, and the thickness (height) of the cube is much smaller than the length and width of the cube; the initial chip substrate has two surfaces (being two opposite surfaces of the cube) determined by a long side and a wide side, the first surface is either one of the two surfaces, and the second surface is the other surface; the pattern-etched surface is taken as the back surface (the first surface) of the chip substrate, and the surface which is not subjected to pattern etching and remains intact during the etching is taken as the front surface (the second surface) of the chip substrate. An intact second surface characterizes that no pattern etching is performed on the second surface and that during the pattern etching of the first surface, the second surface is not affected by the etching and remains intact, for example, the second surface is not perforated during the etching of the first surface.

In some embodiments, the target pattern has a cubic depression at a central position of the first surface in response to the initial eigenfrequency being less than the quantum operating frequency. The target pattern has a cubic boss at the central position of the first surface in response to the initial eigenfrequency being not less than the quantum operating frequency. Minimization or maximization of eigenfrequency may be implemented by simple target patterns according to the embodiments of this application, effectively improving pattern etching efficiency.

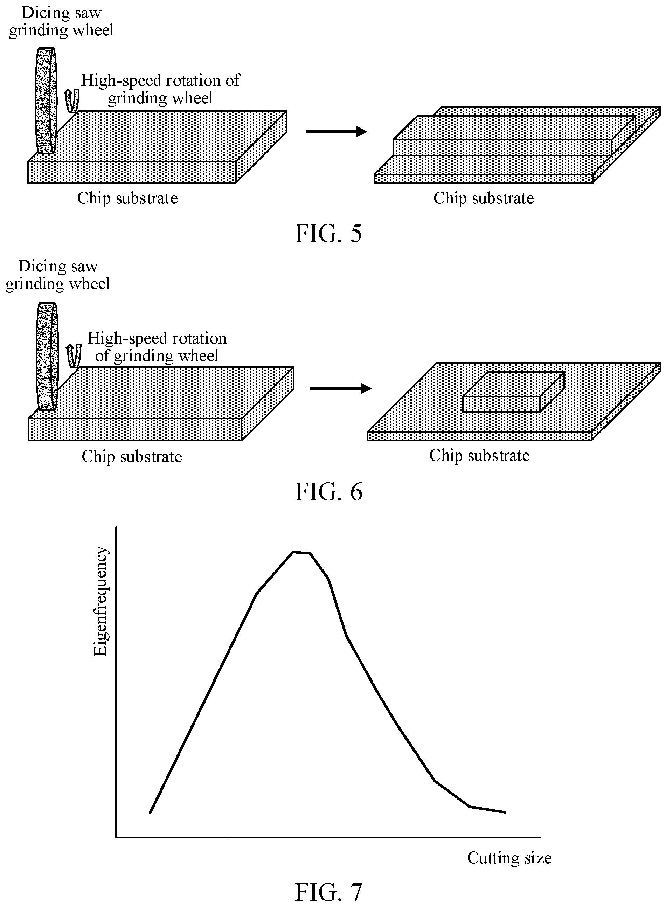

As an example, the chip substrate may be seen as a resonant cavity; before etching the back surface, the chip substrate is a two-dimensional resonant cavity; after etching the back surface, since the shape of the resonant cavity changes, the standing wave field formed along the longitudinal direction of the axis changes, thereby causing the eigenfrequency of the substrate to change. When the eigenfrequency of the substrate is not less than the operating frequency of a quantum bit, reference is made to FIG. 5 and FIG. 6; and FIG. 5 and FIG. 6 schematically show a method for machining a groove on the back surface of the chip substrate using a dicing saw grinding wheel; at the time of cutting, the cutting depth of the grinding wheel to the chip substrate may be set to 330 microns, and the remaining thickness of the chip substrate may be 100 microns. The amount of lateral removal of the dicing saw grinding wheel when cutting from one side of the chip substrate to the other side is 200 microns, that is, a groove with a width of 200 microns and a depth of 330 microns may be cut every time; the back surface of the chip substrate may be processed into a boss shape as shown in FIG. 5, and further, the periphery of the back surface of the chip substrate may be sequentially removed and processed into a boss shape with a central protrusion as shown in FIG. 6. FIG. 7 shows the relationship between the eigenfrequency of the substrate and the amount of material removal from the chip substrate. As the removal amount on two sides or around the back surface of the chip substrate increases, the eigenfrequency of the chip substrate will obviously increase; and then as the removal amount continues to increase, the eigenfrequency of the chip substrate will start to decrease until the removal of the material with a thickness of 330 microns on the back surface is completed, at which time the side length of the chip substrate is 10 millimeters and the thickness of the chip substrate is 100 microns, which is equivalent to the need to obtain the corresponding target pattern when the eigenfrequency is the maximum in FIG. 7, that is, the cubic boss with a raised center as shown in FIG. 6.

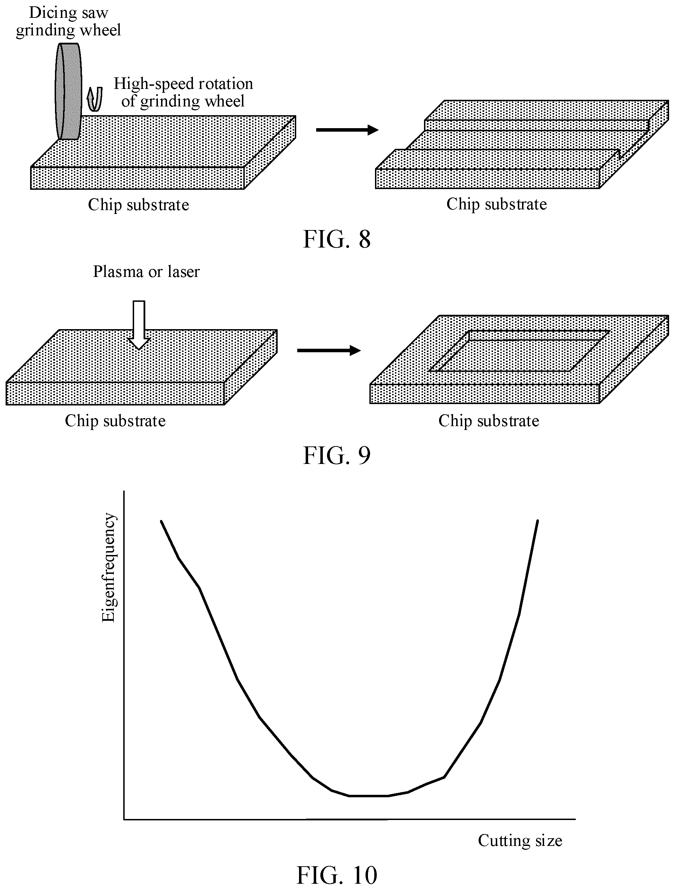

As an example, when the eigenfrequency of the substrate is less than the operating frequency of quantum bits, reference is made to FIG. 8. FIG. 8 schematically illustrates the manner grooves are machined on the back surface of a sapphire substrate using a dicing saw grinding wheel. At this time, the cutting parameters of the dicing saw grinding wheel may be set. For example, a groove is etched in the middle portion. A groove with a width of 200 micrometers and a depth of 330 micrometers may be obtained for each cutting; the number of cuttings may be precisely controlled, and the shape shown in FIG. 8 may be obtained after a plurality of cuttings, or only the central region may be processed. However, the dicing saw may only completely dice from one side of the chip to the other side of the chip. Referring to FIG. 10, FIG. 10 shows the relationship between the eigenfrequency of the sapphire substrate and the removal amount from the sapphire substrate. As the amount of material removal increases, the eigenfrequency of the chip substrate first decreases significantly, then increases as the amount of material removal continues to increase, and finally approaches the eigenfrequency of the original chip substrate. Therefore, in practical processing, it is also necessary to precisely control the amount of material removal to reach the maximum value of the difference between the eigenfrequency of the chip substrate and the operating frequency of the quantum bit, which is equivalent to obtaining a corresponding target pattern in response to the eigenfrequency being minimum in FIG. 10, that is, a cubic depression with a central protrusion as shown in FIG. 8.

Step 103: Etch, on the second surface of the pattern-etched chip substrate, the quantum circuit to form the quantum chip.

As an example, the pattern-etched chip substrate is the chip substrate obtained by step 102, namely, in this case, the first surface of the chip substrate includes a target pattern; a quantum bit circuit (namely, the quantum circuit in step 103) is prepared on the second surface (front surface) of the chip substrate, and the prepared quantum circuit includes circuit structures such as a reading circuit, a filter, a resonant cavity, and a Josephson junction.

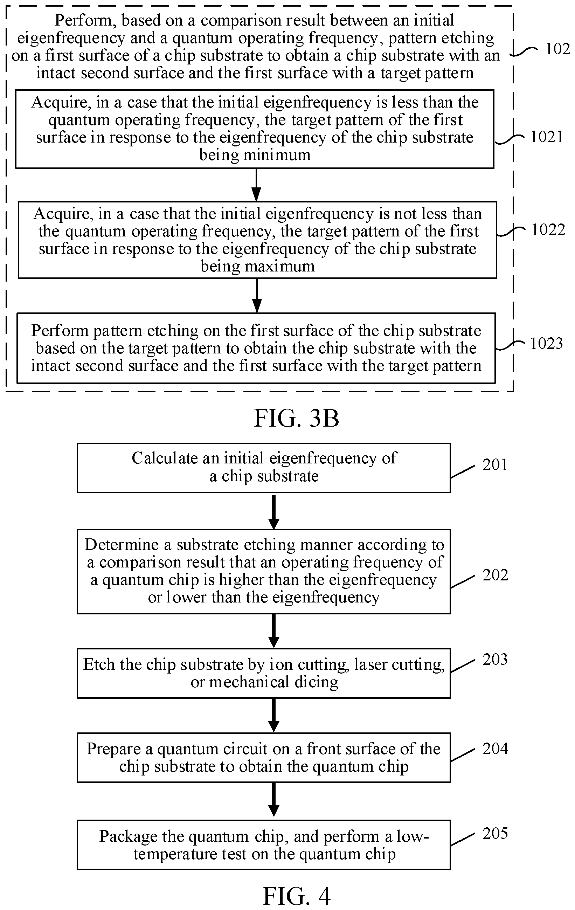

In some embodiments, referring to FIG. 3B, FIG. 3B is a flow diagram of a preparation method for a quantum chip provided by an embodiment of this application. The performing, based on a numerical comparison result between the initial eigenfrequency and a quantum operating frequency, pattern etching on a first surface of the chip substrate to obtain a chip substrate with an intact second surface and the first surface with a target pattern in step 102 may be implemented by performing steps 1021 to 1023 shown in FIG. 3B.

Step 1021: Acquire, when the initial eigenfrequency is less than the quantum operating frequency, the target pattern of the first surface in response to the eigenfrequency of the chip substrate being minimum.

Step 1022: Acquire, when the initial eigenfrequency is not less than the quantum operating frequency, the target pattern of the first surface in response to the eigenfrequency of the chip substrate being maximum.

Step 1023: Perform pattern etching on the first surface of the chip substrate based on the target pattern to obtain the chip substrate with the intact second surface and the first surface with the target pattern.

In some embodiments, the acquiring the target pattern of the first surface in response to the eigenfrequency of the chip substrate being minimum may be implemented by the following technical solutions: acquiring geometric parameters of the chip substrate, material of the chip substrate, and a plurality of candidate patterns of the chip substrate; and calling a first neural network model to perform the following processing: acquiring geometric features corresponding to the geometric parameters, material features corresponding to the material, and pattern features of each candidate pattern; fusing, for each candidate pattern, the geometric features, the material features, and the pattern features of the candidate patterns to obtain a first fusion feature, and performing first mapping on the first fusion feature to obtain prediction eigenfrequencies of the candidate pattern; and ranking the prediction eigenfrequencies of the plurality of candidate patterns from small to large, and taking the candidate pattern corresponding to the prediction eigenfrequency ranked first as the target pattern, thus acquiring the target pattern of the chip substrate with the minimum eigenfrequency.

In some embodiments, the acquiring the target pattern of the first surface in response to the eigenfrequency of the chip substrate being maximum may be implemented by the following technical solutions: acquiring geometric parameters of the chip substrate, material of the chip substrate, and a plurality of candidate patterns of the chip substrate; and calling a first neural network model to perform the following processing: acquiring geometric features corresponding to the geometric parameters, material features corresponding to the material, and pattern features of each candidate pattern; fusing, for each candidate pattern, the geometric features, the material features, and the pattern features of the candidate patterns to obtain a first fusion feature, and performing first mapping on the first fusion feature to obtain prediction eigenfrequencies of the candidate pattern; and ranking the prediction eigenfrequencies of the plurality of candidate patterns from large to small, and taking the candidate pattern corresponding to the prediction eigenfrequency ranked first as the target pattern, thus acquiring the target pattern of the chip substrate with the maximum eigenfrequency.

The eigenfrequencies of each candidate pattern are predicted via artificial intelligence, so that the candidate pattern corresponding to the maximum eigenfrequency is selected as the target pattern, or the candidate pattern corresponding to the minimum eigenfrequency is selected as the target pattern, improving the acquisition efficiency of the target pattern to improve the pattern etching efficiency.

The training process of the above first neural network model is described as follows: acquiring sample geometric parameters of sample chip substrate, a sample material of the sample chip substrate, and a plurality of sample candidate patterns of the sample chip substrate; and calling an initialized first neural network model to perform the following processing: acquiring sample geometric features corresponding to the sample geometric parameters, sample material features corresponding to the sample material, and sample pattern features of each sample candidate pattern; fusing, for each sample candidate pattern, the sample geometric features, the sample material features, and the sample pattern features of the sample candidate patterns to obtain a first sample fusion feature, and performing first mapping on the first sample fusion feature to obtain prediction eigenfrequencies of the sample candidate pattern; and determining an error between the prediction eigenfrequency of the sample candidate pattern and a marker eigenfrequency of the sample candidate pattern, updating parameters of the first neural network model based on the error, and taking the updated first neural network model when the error converges to a minimum value as a first neural network model to be called subsequently.

In some embodiments, the first surface of the chip substrate is a plane, and before the acquiring the target pattern of the first surface in response to the eigenfrequency of the chip substrate being minimum, a plurality of simulated cuttings are performed on the first surface of the chip substrate until the first surface of the chip substrate becomes the plane again. The following processing is performed on the first surface of the chip substrate obtained from each simulated cutting: performing simulation propagation of an electromagnetic wave on the first surface of the chip substrate, and acquiring transmission frequencies of the electromagnetic wave in occurring a resonance phenomenon during the propagation; and ranking the transmission frequencies corresponding to each simulated cutting from small to large, and determining the transmission frequency ranked first as an eigenfrequency being minimum.

As an example, the chip substrate is a rectangular parallelepiped with an initial thickness, and the first surface of the chip substrate is subjected to a plurality of simulated cutting, namely, not performing real cutting for the chip substrate, but performing simulated cutting to obtain the first surface of the chip substrate after being cut, until the first surface of the chip substrate becomes a plane again, which is equivalent to until the chip substrate becomes a rectangular parallelepiped again, but the thickness is reduced relative to the initial thickness. A first surface with different patterns may be obtained for each simulated cutting, and simulation propagation of an electromagnetic wave is performed on the first surface of the chip substrate. The simulation propagation of the electromagnetic wave on the first surface of each pattern may be realized by the simulation software; the transmission frequency of the electromagnetic wave when the resonance phenomenon occurs in the propagation process is taken as the eigenfrequency of the corresponding pattern; the transmission frequencies corresponding to each simulated cutting are ranked from small to large; the transmission frequency ranked first is determined as the eigenfrequency being minimum; that is, the pattern corresponding to the transmission frequency ranked first is taken as the target pattern.

In some embodiments, the first surface of the chip substrate is a plane, and before the acquiring the target pattern of the first surface in response to the eigenfrequency of the chip substrate being maximum, a plurality of simulated cuttings are performed on the first surface of the chip substrate until the first surface of the chip substrate becomes the plane again. The following processing is performed on the first surface of the chip substrate obtained from each simulated cutting: performing simulation propagation of an electromagnetic wave on the first surface of the chip substrate, and acquiring transmission frequencies of the electromagnetic wave in occurring a resonance phenomenon during the propagation; and ranking the transmission frequencies corresponding to each simulated cutting from large to small, and determining the transmission frequency ranked first as an eigenfrequency being maximum.

As an example, the chip substrate is a rectangular parallelepiped with an initial thickness, and the first surface of the chip substrate is subjected to a plurality of simulated cutting, namely, not performing real cutting for the chip substrate, but performing simulated cutting to obtain the first surface of the chip substrate after being cut, until the first surface of the chip substrate becomes a plane again, which is equivalent to until the chip substrate becomes a rectangular parallelepiped again, but the thickness is reduced relative to the initial thickness. A first surface with different patterns may be obtained for each simulated cutting, and electromagnetic waves are simulated to propagate on the first surface of the chip substrate. The simulation propagation of the electromagnetic wave on the first surface of each pattern may be realized by the simulation software; the transmission frequency of the electromagnetic wave when the resonance phenomenon occurs in the propagation process is taken as the eigenfrequency of the corresponding pattern; the transmission frequencies corresponding to each simulated cutting are ranked from large to small; the transmission frequency ranked first is determined as the eigenfrequency being maximum; that is, the pattern corresponding to the transmission frequency ranked first is taken as the target pattern.

According to the embodiments of this application, a plurality of simulated cutting may be performed to obtain a plurality of first surfaces with different patterns after simulated cutting; and the eigenfrequencies corresponding to the first surfaces of each pattern may be obtained via simulation test, to determine a pattern with the maximum or minimum eigenfrequency as a target pattern, and the target pattern may be accurately obtained.

In some embodiments, any simulated cutting is any one of the following processing: acquiring a grinding wheel cutting unit, and performing simulated cutting on the first surface of the chip substrate based on the grinding wheel cutting unit, for example, measuring the position of the chip substrate using a microscope system built in the dicing saw, to determine the height from the chip substrate to the grinding wheel; and setting cutting parameters for the chip substrate for each cutting with a pre-calibrated grinding wheel. Taking a square chip substrate with a side length of 10 millimeters and a thickness of 430 microns as an example (a grinding wheel cutting unit), for a chip substrate with a thickness of 430 microns, the cutting depth of the grinding wheel to the chip substrate may be set to 330 microns during cutting, and the remaining thickness of the chip substrate is 100 microns. The amount of lateral removal of the dicing saw grinding wheel when cutting from one side of the chip substrate to the other side is 200 microns, that is, a groove with a width of 200 microns and a depth of 330 microns may be cut every time. A movement trajectory of a simulated beam on the first surface of the chip substrate and a residence time of the simulated beam corresponding to each position during the movement are acquired, and simulated cutting is performed on the first surface of the chip substrate based on the movement trajectory and the residence time, for example, machining the center of the chip may also be performed using a focused plasma or a laser. First, the position where the plasma is focused on the chip substrate or the position where the laser beam is focused on the chip substrate is precisely controlled, and then the trajectory of movement of the focused plasma or the laser beam and the residence time at each position on the substrate are controlled by a program to remove the material on the chip substrate, and finally, the chip substrate with a groove in the middle is processed as shown in FIG. 9.

In some embodiments, the chip substrate of the quantum chip includes an opposing first surface and second surface; the first surface having a target pattern, the target pattern being a pattern when a difference between an eigenfrequency of the chip substrate and a quantum operating frequency is maximum; the second surface is provided with a quantum circuit, and an operating frequency of a quantum bit of the quantum circuit is the quantum operating frequency.

As an example, firstly, an initial eigenfrequency of the chip substrate is determined; and then, based on a numerical comparison result between the initial eigenfrequency and a quantum operating frequency, pattern etching is performed on a first surface of the chip substrate to obtain a chip substrate with an intact second surface and the first surface with a target pattern, the quantum operating frequency being an operating frequency of a quantum bit of the quantum circuit, the second surface being opposite to the first surface, and the target pattern being a pattern when a difference between the eigenfrequency of the chip substrate and the quantum operating frequency is maximum; and finally, the quantum circuit is etched on the second surface of the pattern-etched chip substrate to form a quantum chip.

Pattern etching is performed on a first surface of the chip substrate based on a numerical comparison result between the initial eigenfrequency and a quantum operating frequency to obtain a chip substrate with an intact second surface and the first surface with a target pattern; since the target pattern is a pattern when a difference between the eigenfrequency of the chip substrate and the quantum operating frequency is maximum, the effect of the eigenfrequency of the chip substrate on the coherence of the quantum bit can be eliminated, thereby increasing the computing capability of the quantum chip. The quantum circuit is etched on the second surface of the pattern-etched chip substrate, to form the quantum chip; since the pattern is etched on the first surface of the chip substrate, the morphology and size of the second surface of the chip substrate are not affected, so that the quantum circuit can be normally prepared.

In the following, exemplary applications of the embodiments of this application in a practical application scene will be described.

In some embodiments, the preparation method for a quantum chip provided in the embodiments of this application may be implemented by a terminal cooperating with a server; the server determines an initial eigenfrequency of a chip substrate; the server compares the initial eigenfrequency of the chip substrate with a quantum operating frequency; the server determines a target pattern based on a numerical comparison result; the target pattern is sent to the terminal; the terminal performs pattern etching on a first surface of the chip substrate to obtain a chip substrate with an intact second surface and the first surface with the target pattern. The quantum operating frequency is an operating frequency of a quantum bit of the quantum circuit; the second surface is opposite to the first surface; the target pattern is a pattern when a difference between the eigenfrequency of the chip substrate and the quantum operating frequency is maximum. The terminal etches the quantum circuit on the second surface of the pattern-etched chip substrate to form a quantum chip.

The embodiments of this application adjust the eigenfrequency of the substrate by etching a pattern on the back surface of the substrate to change the overall shape of the substrate, and enlarge the distance between the operating frequency of the quantum bit and the eigenfrequency of the substrate, so that the influence of the substrate mode on the bit coherence may be significantly reduced and the bit coherence time may be prolonged.

The preparation method for a quantum chip provided by the embodiments of this application is to change the eigenfrequency of the eigenmode of the substrate using a pattern etched on the back surface of the substrate, so that the difference between the operating frequency of the quantum bit and the eigenfrequency of the substrate is enlarged, thus reducing the effect of the eigenmode of the chip substrate on the coherence of the quantum bit and extending the coherence time.

With reference to FIG. 4, FIG. 4 is a flow diagram of a preparation method for a quantum chip provided by an embodiment of this application. Step 201: Calculate an initial eigenfrequency of a chip substrate. Specifically, since the thickness of the chip substrate is much smaller than the length and width of the chip, the chip substrate may be considered as a two-dimensional resonant cavity, and the calculation of the initial eigenfrequency may be seen in formula (3):

$$f = \frac{1}{2\pi\sqrt{\mu\varepsilon}}\sqrt{(\frac{\pi}{l})^2 + (\frac{\pi}{w})^2} \qquad (3)$$

$\mu$ and $\varepsilon$ are the permeability and dielectric constant, respectively, of the chip substrate; l and w are the length and width, respectively, of the chip substrate.

The simulation software may also be used to output the eigenfrequency of the chip substrate; and after obtaining the eigenfrequency of the chip substrate, the initial eigenfrequency is compared to the operating frequency of the quantum bits.

Step 202: Determine a substrate etching manner according to a numerical comparison result that the operating frequency of the quantum chip is higher than the eigenfrequency or lower than the eigenfrequency. Specifically, an etched target pattern is determined; when the operating frequency of the quantum bits is less than the eigenfrequency of the chip substrate, the target pattern is to be etched to move the eigenfrequency of the chip substrate to a high frequency; and when the operating frequency of the quantum bits is not less than the eigenfrequency of the chip substrate, the target pattern is to be etched to move the eigenfrequency of the chip substrate to a low frequency.

Step 203: Etch the chip substrate by ion cutting, laser cutting, or mechanical dicing; and specifically, etch a target pattern on the back surface of the chip substrate by ion cutting, laser cutting, or mechanical dicing, for example, a groove structure or a boss structure is etched, and precisely control the size of the groove or the boss to maximize the difference between the eigenfrequency of the chip substrate and the operating frequency of the quantum bit.

Step 204: Etch a quantum circuit on the front surface of the chip substrate to form a quantum chip; and specifically, prepare, since the size and morphology of the front surface are not affected by the pattern etching, a quantum bit circuit on the front surface, the quantum bit circuit including a structure such as a reading circuit, a filter, a resonant cavity, and a Josephson junction.

Step 205: Package the quantum chip, and perform a low-temperature test on the quantum chip, specifically, run a quantum algorithm after the quantum chip is put into a refrigerator.

In some embodiments, when the eigenfrequency of the substrate is not less than the operating frequency of the quantum bit, reference is made to FIG. 5 and FIG. 6. FIG. 5 and FIG. 6 schematically illustrate the manner grooves are machined on the back surface of a sapphire substrate using a dicing saw grinding wheel, which may be done directly with a commercial dicing saw. The front surface of the sapphire was first attached to a special iron ring with a blue film, and then the back surface of the sapphire was placed into the dicing saw towards the grinding wheel. The position of the sapphire is then measured using a microscope system built into the dicing saw to determine the height of the sapphire to the grinding wheel. Cutting parameters are set for the sapphire for each cutting with a pre-calibrated grinding wheel. Taking a square sapphire with a side length of 10 millimeters and a thickness of 430 microns as an example, for a sapphire substrate with a thickness of 430 microns, the cutting depth of the grinding wheel to the sapphire may be set to 330 microns during cutting, and the remaining thickness of the sapphire is 100 microns. The amount of lateral removal of the dicing saw grinding wheel when cutting from one side of the sapphire to the other side is 200 microns, that is, a groove with a width of 200 microns and a depth of 330 microns may be cut every time; the back surface of the sapphire could be machined into a boss shape as shown in FIG. 5. It is further possible to sequentially remove the periphery of the back surface of the sapphire and process into a boss shape with a central protrusion as shown in FIG. 6

In some embodiments, FIG. 7 shows the relationship between the eigenfrequency of the sapphire substrate and the removal amount from the sapphire substrate. As the removal amount on two sides or around the back surface of the sapphire increases, the eigenfrequency of the sapphire increases significantly; then as the removal amount continues to increase, the sapphire structure approaches a thin complete sapphire; and then the eigenfrequency of the sapphire begins to decrease until the removal of the sapphire with a 330-microns thickness on the back surface is completed, at which the size of the sapphire is 10 millimeters on the side and 100 microns in thickness. The difference between the eigenfrequency of the sapphire and the eigenfrequency with a thickness of 430 microns is small. Therefore, in practical operation, it is necessary to accurately select an appropriate removal amount to maximize the difference between the eigenfrequency of the sapphire and the operating frequency of the quantum bit.

In some embodiments, the eigenfrequency of the substrate may continue to decrease when the eigenfrequency of the substrate is not higher than the operating frequency of the quantum bit. FIG. 8 schematically illustrates the manner grooves are machined on the back surface of a sapphire substrate using a dicing saw grinding wheel. At this time, the cutting parameters of the dicing saw grinding wheel may be set. For example, a groove is etched in the middle portion. A groove with a width of 200 micrometers and a depth of 330 micrometers may be obtained for each cutting; the number of cuttings may be precisely controlled, and the shape shown in FIG. 8 may be obtained after a plurality of cuttings.

In some embodiments, it is also possible to process only the central region. However, the dicing saw may only completely dice from one side of the chip to the other side of the chip. Therefore, if only the central region of the chip is processed, the dicing saw cannot be used. Referring to FIG. 9, the center of the chip may now be processed using a focused plasma or laser. First, the position where the plasma is focused on the chip substrate or the position where the laser beam is focused on the chip substrate is precisely controlled, and then the trajectory of movement of the focused plasma or the laser beam and the residence time at each position on the substrate are controlled by a program to remove the material on the chip substrate, and finally the chip substrate with a groove in the middle is processed as shown in FIG. 9.

In some embodiments, referring to FIG. 10, FIG. 10 shows the relationship between the eigenfrequency of the sapphire substrate and the removal amount from the sapphire substrate. As the amount of material removal increases, the eigenfrequency of the chip substrate first decreases significantly, then increases as the amount of material removal continues to increase, and finally approaches the eigenfrequency of the original chip substrate. Therefore, in practical processing, it is also necessary to precisely control the amount of material removal to reach the maximum value of the difference between the eigenfrequency of the chip substrate and the operating frequency of the quantum bit.

By etching a boss or pit pattern on the back surface of the chip substrate through the embodiment of this application, the eigenfrequency of the chip substrate may be significantly increased or decreased, and the difference between the eigenfrequency of the chip substrate and the operating frequency of the quantum bit may be increased, thereby prolonging the coherence time. Since the pattern is etched on the back surface of the chip substrate, the morphology and size of the front surface of the chip substrate are not affected, and the subsequent processing of the quantum chip is not affected. There is no requirement for the kind of the chip substrate; in addition to a sapphire substrate, a silicon substrate or a silicon carbide substrate with good compatibility may also be provided.

The following continues to illustrate an exemplary structure of a preparation apparatus 455 for a quantum chip provided by the embodiments of this application implemented as a software module. In some embodiments, as shown in FIG. 4, a software module stored in the preparation apparatus 455 for the quantum chip of a memory 450 may include: a determination module 4551, configured to determine an initial eigenfrequency of a chip substrate; an etching module 4554, configured to perform, based on a numerical comparison result between the initial eigenfrequency and a quantum operating frequency, pattern etching on a first surface of the chip substrate to obtain a chip substrate with an intact second surface and the first surface with a target pattern; the quantum operating frequency being an operating frequency of a quantum bit of a quantum circuit, the second surface being opposite to the first surface, and the target pattern being a pattern when a difference between the eigenfrequency of the chip substrate and the quantum operating frequency is maximum; and a preparation module 4553, configured to etch, on the second surface of the pattern-etched chip substrate, the quantum circuit to form the quantum chip.

In some embodiments, the determination module 4551 is further configured to: acquire a length and width of the first surface when the first surface of the chip substrate is a rectangle; and determine the initial eigenfrequency of the chip substrate based on the length and the width of the first surface.

In some embodiments, the determination module 4551 is further configured to: square the length to obtain a first square result, and square the width to obtain a second square result; determine a first ratio of a square result of a circumference rate constant to the first square result, and a second ratio of the square result of the circumference rate constant to the second square result; extract a sum result of the first ratio and the second ratio to obtain an extraction result; and take a ratio of the extraction result to a substrate constant as the initial eigenfrequency, the substrate constant being obtained based on permeability of the chip substrate and a dielectric constant of the chip substrate.

In some embodiments, the etching module 4554 is further configured to: acquire, when the initial eigenfrequency is less than the quantum operating frequency, the target pattern of the first surface in response to the eigenfrequency of the chip substrate being minimum before the performing, based on a numerical comparison result between the initial eigenfrequency and a quantum operating frequency, pattern etching on a first surface of the chip substrate to obtain a chip substrate with an intact second surface and the first surface with a target pattern; and acquire, when the initial eigenfrequency is not less than the quantum operating frequency, the target pattern of the first surface in response to the eigenfrequency of the chip substrate being maximum.

In some embodiments, the target pattern has a cubic depression at a central position of the first surface in response to the initial eigenfrequency being less than the quantum operating frequency. The target pattern has a cubic boss at the central position of the first surface in response to the initial eigenfrequency being not less than the quantum operating frequency.

In some embodiments, the etching module 4554 is further configured to: acquire, before the acquiring the target pattern of the first surface in response to the eigenfrequency of the chip substrate being minimum, geometric parameters of the chip substrate, material of the chip substrate, and a plurality of candidate patterns of the chip substrate; and call a first neural network model to perform the following processing: acquire geometric features corresponding to the geometric parameters, material features corresponding to the material, and pattern features of each candidate pattern; fuse, for each candidate pattern, the geometric features, the material features, and the pattern features of the candidate patterns to obtain a first fusion feature, and perform first mapping on the first fusion feature to obtain prediction eigenfrequencies of the candidate pattern; and rank the prediction eigenfrequencies of the plurality of candidate patterns from small to large, and taking the candidate pattern corresponding to the prediction eigenfrequency ranked first as the target pattern.

In some embodiments, the etching module 4554 is further configured to: acquire, before the acquiring the target pattern of the first surface in response to the eigenfrequency of the chip substrate being maximum, geometric parameters of the chip substrate, material of the chip substrate, and a plurality of candidate patterns of the chip substrate; and call a first neural network model to perform the following processing: acquire geometric features corresponding to the geometric parameters, material features corresponding to the material, and pattern features of each candidate pattern; fuse, for each candidate pattern, the geometric features, the material features, and the pattern features of the candidate patterns to obtain a first fusion feature, and perform first mapping on the first fusion feature to obtain prediction eigenfrequencies of the candidate pattern; and rank the prediction eigenfrequencies of the plurality of candidate patterns from large to small, and taking the candidate pattern corresponding to the prediction eigenfrequency ranked first as the target pattern.

In some embodiments, the first surface of the chip substrate is a plane; and the etching module 4554 is further configured to: perform, before the acquiring the target pattern of the first surface in response to the eigenfrequency of the chip substrate being minimum, a plurality of simulated cutting on the first surface of the chip substrate until the first surface of the chip substrate becomes the plane again; and perform the following processing on the first surface of the chip substrate obtained from each simulated cutting: performing simulation propagation of an electromagnetic wave on the first surface of the chip substrate, and acquiring transmission frequencies of the electromagnetic wave in occurring a resonance phenomenon during the propagation; and ranking the transmission frequencies corresponding to each simulated cutting from small to large, and determining the transmission frequency ranked first as an eigenfrequency being minimum.

In some embodiments, the first surface of the chip substrate is a plane; and the etching module 4554 is further configured to: perform, before the acquiring the target pattern of the first surface in response to the eigenfrequency of the chip substrate being maximum, a plurality of simulated cutting on the first surface of the chip substrate until the first surface of the chip substrate becomes the plane again; and perform the following processing on the first surface of the chip substrate obtained from each simulated cutting: performing simulation propagation of an electromagnetic wave on the first surface of the chip substrate, and acquiring transmission frequencies of the electromagnetic wave in occurring a resonance phenomenon during the propagation; and ranking the transmission frequencies corresponding to each simulated cutting from large to small, and determining the transmission frequency ranked first as an eigenfrequency being maximum.

In some embodiments, any simulated cutting is any one of the following processing: acquiring a grinding wheel cutting unit, and performing simulated cutting on the first surface of the chip substrate based on the grinding wheel cutting unit; and acquiring a movement trajectory of a simulated beam on the first surface of the chip substrate and a residence time of the simulated beam corresponding to each position during the movement, and performing simulated cutting on the first surface of the chip substrate based on the movement trajectory and the residence time.

The embodiments of this application provide a quantum chip, a chip substrate of the quantum chip including an opposing first surface and second surface; the first surface having a target pattern, the target pattern being a pattern when a difference between an eigenfrequency of the chip substrate and a quantum operating frequency is maximum; and the second surface being provided with a quantum circuit, an operating frequency of a quantum bit of the quantum circuit being the quantum operating frequency.

The embodiments of this application provide a computer program product or computer program including computer instructions, the computer instructions being stored in a computer-readable storage medium. A processor of an electronic device reads the computer instructions from the computer-readable storage medium, and the processor executes the computer instructions to cause the electronic device to execute the above preparation method for a quantum chip in the embodiments of this application.

The embodiments of this application provide a computer-readable storage medium storing therein executable instructions. The executable instructions, when executed by a processor, implement the preparation method for a quantum chip provided by the embodiments of this application, for example, the preparation method for a quantum chip illustrated in FIGs. 3A-3B.

In some embodiments, the computer-readable storage medium may be a memory such as FRAM, ROM, PROM, EPROM, EEPROM, flash memory, magnetic surface storage, optical disk, or CD-ROM; or various devices including one or any combination of the above memories.

In some embodiments, the executable instructions may be written in any form of program, software, software module, script, or code, in any form of programming language, including compiled or interpreted languages, or declarative or procedural languages. They may be deployed in any form, including as stand-alone programs or as modules, assemblies, subroutines, or other units suitable for use in a computing environment.

As an example, the executable instructions may, but need not, correspond to files in a file system, may be stored in a portion of a file that holds other programs or data, for example, in one or more scripts in a hyper text markup language (HTML) document, in a single file dedicated to the program in question, or in multiple coordinated files (for example, files storing one or more modules, subroutines, or portions of code).

As an example, the executable instructions may be deployed to be executed on one electronic device, or on multiple electronic devices located at one site, or on multiple electronic devices distributed across multiple sites and interconnected by a communication network.

In summary, according to the embodiment of this application, pattern etching is performed on a first surface of the chip substrate based on a numerical comparison result between the initial eigenfrequency and a quantum operating frequency to obtain a chip substrate with an intact second surface and the first surface with a target pattern; since the target pattern is a pattern when a difference between the eigenfrequency of the chip substrate and the quantum operating frequency is maximum, the effect of the eigenfrequency of the chip substrate on the coherence of the quantum bit can be eliminated, thereby ensuring that the quantum circuit may operate normally. The quantum circuit is etched on the second surface of the pattern-etched chip substrate, to form the quantum chip; since the pattern is etched on the first surface of the chip substrate, the morphology and size of the second surface of the chip substrate are not affected, so that a quantum circuit may be prepared, obtaining a quantum chip operating normally.

The above is only embodiments of this application and is not intended to limit the scope of protection of this application. Any modification, equivalent replacement, improvement, and the like made within the scope of this application shall be included in the scope of protection of this application.

**Claims**

1. A method for preparing a quantum chip executable by an electronic device, the method comprising:

   determining an initial eigenfrequency of a chip substrate;
   performing, based on a comparison result between the initial eigenfrequency and a quantum operating frequency, pattern etching on a first surface of the chip substrate to obtain a chip substrate with an intact second surface and the first surface with a target pattern;
   the quantum operating frequency being an operating frequency of a quantum bit of a quantum circuit, the second surface being opposite to the first surface, and the target pattern being a pattern when a difference between the eigenfrequency of the chip substrate and the quantum operating frequency is maximum; and
   etching, on the second surface of the chip substrate, the quantum circuit to form the quantum chip.

2. The method according to claim 1, wherein the determining an initial eigenfrequency of a chip substrate comprises:

   acquiring a length and a width of the first surface when the first surface of the chip substrate is rectangular; and
   determining the initial eigenfrequency of the chip substrate based on the length and the width of the first surface.

3. The method according to claim 2, wherein the determining the initial eigenfrequency of the chip substrate based on the length and the width of the first surface comprises:

   squaring the length to obtain a first square result, and squaring the width to obtain a second square result;
   determining a first ratio of a square result of a circumference rate constant to the first square result, and a second ratio of the square result of the circumference rate constant to the second square result;
   extracting a sum of the first ratio and the second ratio to obtain an extraction result; and
   taking a ratio of the extraction result to a substrate constant as the initial eigenfrequency, the substrate constant being obtained based on permeability of the chip substrate and a dielectric constant of the chip substrate.

4. The method according to claim 1, wherein the performing, based on a numerical comparison result between the initial eigenfrequency and a quantum operating frequency, pattern etching on a first surface of the chip substrate to obtain a chip substrate with an intact second surface and the first surface with a target pattern comprises:

   acquiring, when the initial eigenfrequency is less than the quantum operating frequency, the target pattern of the first surface in response to the eigenfrequency of the chip substrate being minimum;
   acquiring, when the initial eigenfrequency is not less than the quantum operating frequency, the target pattern of the first surface in response to the eigenfrequency of the chip substrate being maximum; and
   performing pattern etching on the first surface of the chip substrate based on the target pattern to obtain the chip substrate with the intact second surface and the first surface with the target pattern.

5. The method according to claim 4, wherein the acquiring the target pattern of the first surface in response to the eigenfrequency of the chip substrate being minimum comprises:

   acquiring geometric parameters of the chip substrate, material of the chip substrate, and a plurality of candidate patterns of the chip substrate; and
   performing the following processing using a first neural network model:

   acquiring geometric features corresponding to the geometric parameters, material features corresponding to the material, and pattern features of each of the plurality of candidate pattern;
   fusing, for each of the plurality of candidate pattern, the geometric features, the material features, and the pattern features of the candidate patterns to obtain a first fusion feature, and performing first mapping on the first fusion feature to obtain prediction eigenfrequencies of the candidate pattern; and
   ranking the prediction eigenfrequencies of the plurality of candidate patterns from small to large, and taking the candidate pattern corresponding to a prediction eigenfrequency ranked first as the target pattern.

**6.** The method according to claim 4, wherein the acquiring the target pattern of the first surface in response to the eigenfrequency of the chip substrate being maximum comprises:

acquiring geometric parameters of the chip substrate, material of the chip substrate, and a plurality of candidate patterns of the chip substrate; and
performing the following processing using a first neural network model:

acquiring geometric features corresponding to the geometric parameters, material features corresponding to the material, and pattern features of each of the plurality of candidate pattern;
fusing, for each of the plurality of candidate pattern, the geometric features, the material features, and the pattern features of the candidate patterns to obtain a first fusion feature, and performing first mapping on the first fusion feature to obtain prediction eigenfrequencies of the candidate pattern; and
ranking the prediction eigenfrequencies of the plurality of candidate patterns from large to small, and taking the candidate pattern corresponding to a prediction eigenfrequency ranked first as the target pattern.

**7.** The method according to claim 4, wherein the first surface of the chip substrate is a plane, and before the acquiring the target pattern of the first surface in response to the eigenfrequency of the chip substrate being minimum, the method further comprises:

performing a plurality of simulated cutting on the first surface of the chip substrate until the first surface of the chip substrate becomes the plane again; and
performing the following processing on the first surface of the chip substrate obtained from each simulated cutting:

performing simulation propagation of an electromagnetic wave on the first surface of the chip substrate, and acquiring transmission frequencies of the electromagnetic wave in occurring a resonance phenomenon during the propagation; and
ranking the transmission frequencies corresponding to each simulated cutting from small to large, and determining a transmission frequency ranked first as the eigenfrequency being minimum.

**8.** The method according to claim 4, wherein the first surface of the chip substrate is a plane, and before the acquiring the target pattern of the first surface in response to the eigenfrequency of the chip substrate being maximum, the method further comprises:

performing a plurality of simulated cutting on the first surface of the chip substrate until the first surface of the chip substrate becomes the plane again; and
performing the following processing on the first surface of the chip substrate obtained from each simulated cutting:

performing simulation propagation of an electromagnetic wave on the first surface of the chip substrate, and acquiring transmission frequencies of the electromagnetic wave in occurring a resonance phenomenon during the propagation; and
ranking the transmission frequencies corresponding to each simulated cutting from large to small, and determining a transmission frequency ranked first as the eigenfrequency being maximum.

**9.** The method according to claim 7 or 8, wherein any simulated cutting is any one of the following processing:

performing simulated cutting on the first surface of the chip substrate based on a grinding wheel cutting unit; and
acquiring a movement trajectory of a simulated beam on the first surface of the chip substrate and a residence time of the simulated beam corresponding to each position during the movement, and performing simulated cutting on the first surface of the chip substrate based on the movement trajectory and the residence time.

**10.** The method according to claim 1, wherein

the target pattern has a cubic depression at a central position of the first surface in response to the initial eigenfrequency being less than the quantum operating frequency; and
the target pattern has a cubic boss at the central position of the first surface in response to the initial eigenfrequency being not less than the quantum operating frequency.

**11.** A quantum chip, a chip substrate of the quantum chip comprising a first surface and a second surface opposite to the first surface; wherein

the first surface has a target pattern, and the target pattern is a pattern when a difference between an eigenfrequency of the chip substrate and a quantum operating frequency is maximum; and
the second surface is provided with a quantum circuit, and an operating frequency of a quantum bit of the quantum circuit is the quantum operating frequency.

12. An apparatus for preparing a quantum chip, the apparatus comprising:

a determination module, configured to determine an initial eigenfrequency of a chip substrate;
an etching module, configured to perform, based on a numerical comparison result between the initial eigenfrequency and a quantum operating frequency, pattern etching on a first surface of the chip substrate to obtain a chip substrate with an intact second surface and the first surface with a target pattern;
the quantum operating frequency being an operating frequency of a quantum bit of a quantum circuit, the second surface being opposite to the first surface, and the target pattern being a pattern when a difference between the eigenfrequency of the chip substrate and the quantum operating frequency is maximum; and
a preparation module, configured to etch, on the second surface of the pattern-etched chip substrate, the quantum circuit to form the quantum chip.

13. An electronic device, the electronic device comprising:

a memory, configured to store computer-executable instructions; and
a processor, configured to implement, when executing the computer-executable instructions stored in the memory, the method according to any one of claims 1 to 10.

14. A computer-readable storage medium storing thereon computer-executable instructions, the computer-executable instructions, when executed by a processor, implementing the method according to any one of claims 1 to 10.

15. A computer program product comprising computer-executable instructions, the computer-executable instructions, when executed by a processor, implementing the method according to any one of claims 1 to 10.

Server <u>200</u>

Target pattern    Pattern etching
request

Network <u>300</u>

Target pattern    Pattern etching
request

Terminal <u>400</u>

FIG. 1

Terminal 400

Memory 450

| | |
|---|---|
| Network interface 420 | Operating system 451 |
| | Network communication module 452 |
| | Presentation module 453 |
| Processor 410 | Input processing module 454 |
| | Chip processing apparatus 455 |

Chip processing apparatus 455

Determination module 4551

Etching module 4552

Preparation module 4553

440

User interface 430

Output apparatus 431

Input apparatus 432

## FIG. 2

Determine an initial eigenfrequency of a chip substrate — 101

Perform, based on a comparison result between the initial eigenfrequency and a quantum operating frequency, pattern etching on a first surface of the chip substrate to obtain a chip substrate with an intact second surface and the first surface with a target pattern — 102

Etch, on the second surface of the pattern-etched chip substrate, a quantum circuit to form a quantum chip — 103

## FIG. 3A

Perform, based on a comparison result between an initial eigenfrequency and a quantum operating frequency, pattern etching on a first surface of a chip substrate to obtain a chip substrate with an intact second surface and the first surface with a target pattern  —102

Acquire, in a case that the initial eigenfrequency is less than the quantum operating frequency, the target pattern of the first surface in response to the eigenfrequency of the chip substrate being minimum  —1021

Acquire, in a case that the initial eigenfrequency is not less than the quantum operating frequency, the target pattern of the first surface in response to the eigenfrequency of the chip substrate being maximum  —1022

Perform pattern etching on the first surface of the chip substrate based on the target pattern to obtain the chip substrate with the intact second surface and the first surface with the target pattern  —1023

## FIG. 3B

Calculate an initial eigenfrequency of a chip substrate  —201

Determine a substrate etching manner according to a comparison result that an operating frequency of a quantum chip is higher than the eigenfrequency or lower than the eigenfrequency  —202

Etch the chip substrate by ion cutting, laser cutting, or mechanical dicing  —203

Prepare a quantum circuit on a front surface of the chip substrate to obtain the quantum chip  —204

Package the quantum chip, and perform a low-temperature test on the quantum chip  —205

## FIG. 4

Dicing saw
grinding wheel

High-speed rotation of
grinding wheel

Chip substrate

Chip substrate

FIG. 5

Dicing saw
grinding wheel

High-speed rotation
of grinding wheel

Chip substrate

Chip substrate

FIG. 6

Eigenfrequency

Cutting size

FIG. 7

Dicing saw grinding wheel

High-speed rotation of grinding wheel

Chip substrate

Chip substrate

FIG. 8

Plasma or laser

Chip substrate

Chip substrate

FIG. 9

Eigenfrequency

Cutting size

FIG. 10

## INTERNATIONAL SEARCH REPORT

| International application No. |
| --- |
| **PCT/CN2023/090539** |

**A.    CLASSIFICATION OF SUBJECT MATTER**

G02B6/136(2006.01)i;  G06N10/80(2022.01)i

According to International Patent Classification (IPC) or to both national classification and IPC

**B.    FIELDS SEARCHED**

Minimum documentation searched (classification system followed by classification symbols)

IPC:G06N,G02B

Documentation searched other than minimum documentation to the extent that such documents are included in the fields searched

Electronic data base consulted during the international search (name of data base and, where practicable, search terms used)

CNTXT , CNKI, DWPI, ENTXT, ENTXTC, WPABS, IEEE, CNABS: 量子, 芯片, 基底, 本征频率, 工作频率, 比值, 刻蚀, 长度, 宽度, 磁导率, 介电常数, quantum, chip, substrate, eigenfrequency, operating frequency, ratio, etch, length, width, magnetic permeability, dielectric constant

**C.    DOCUMENTS CONSIDERED TO BE RELEVANT**

| Category* | Citation of document, with indication, where appropriate, of the relevant passages | Relevant to claim No. |
| --- | --- | --- |
| A | CN 108231992 A (HEFEI ORIGIN QUANTUM COMPUTING TECHNOLOGY CO., LTD.) 29 June 2018 (2018-06-29) entire document | 1-15 |
| A | CN 114142946 A (SHANGHAI INSTITUTE OF MICROSYSTEM AND INFORMATION TECHNOLOGY, CHINESE ACADEMY OF SCIENCES) 04 March 2022 (2022-03-04) entire document | 1-15 |
| A | US 2020335685 A1 (IBM) 22 October 2020 (2020-10-22) entire document | 1-15 |
| A | CN 113887733 A (BEIJING BAIDU NETCOM SCIENCE AND TECHNOLOGY CO., LTD.) 04 January 2022 (2022-01-04) entire document | 1-15 |
| A | CN 113215574 A (NANJING UNIVERSITY) 06 August 2021 (2021-08-06) entire document | 1-15 |

☑ Further documents are listed in the continuation of Box C.      ☑ See patent family annex.

| | |
| --- | --- |
| *    Special categories of cited documents:<br>"A"  document defining the general state of the art which is not considered to be of particular relevance<br>"D"  document cited by the applicant in the international application<br>"E"  earlier application or patent but published on or after the international filing date<br>"L"  document which may throw doubts on priority claim(s) or which is cited to establish the publication date of another citation or other special reason (as specified)<br>"O"  document referring to an oral disclosure, use, exhibition or other means<br>"P"  document published prior to the international filing date but later than the priority date claimed | "T"  later document published after the international filing date or priority date and not in conflict with the application but cited to understand the principle or theory underlying the invention<br>"X"  document of particular relevance; the claimed invention cannot be considered novel or cannot be considered to involve an inventive step when the document is taken alone<br>"Y"  document of particular relevance; the claimed invention cannot be considered to involve an inventive step when the document is combined with one or more other such documents, such combination being obvious to a person skilled in the art<br>"&"  document member of the same patent family |

| Date of the actual completion of the international search | Date of mailing of the international search report |
| --- | --- |
| **09 July 2023** | **13 July 2023** |

| Name and mailing address of the ISA/CN | Authorized officer |
| --- | --- |
| **China National Intellectual Property Administration (ISA/ CN)**<br>**China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

International application No.

**PCT/CN2023/090539**

**C.    DOCUMENTS CONSIDERED TO BE RELEVANT**

| Category* | Citation of document, with indication, where appropriate, of the relevant passages | Relevant to claim No. |
|---|---|---|
| A | CN 114065939 A (BEIJING BAIDU NETCOM SCIENCE AND TECHNOLOGY CO., LTD.) 18 February 2022 (2022-02-18) entire document | 1-15 |
| A | CN 114492810 A (BEIJING BAIDU NETCOM SCIENCE AND TECHNOLOGY CO., LTD.) 13 May 2022 (2022-05-13) entire document | 1-15 |

Form PCT/ISA/210 (second sheet) (July 2022)

## INTERNATIONAL SEARCH REPORT
### Information on patent family members

International application No.

**PCT/CN2023/090539**

| Patent document cited in search report | | | Publication date (day/month/year) | Patent family member(s) | | | Publication date (day/month/year) |
|---|---|---|---|---|---|---|---|
| CN | 108231992 | A | 29 June 2018 | CN | 108231992 | B | 02 August 2019 |
| CN | 114142946 | A | 04 March 2022 | None | | | |
| US | 2020335685 | A1 | 22 October 2020 | US | 10903412 | B2 | 26 January 2021 |
| | | | | US | 2021091295 | A1 | 25 March 2021 |
| | | | | US | 11527697 | B2 | 13 December 2022 |
| CN | 113887733 | A | 04 January 2022 | None | | | |
| CN | 113215574 | A | 06 August 2021 | CN | 113215574 | B | 28 February 2022 |
| CN | 114065939 | A | 18 February 2022 | CN | 114065939 | B | 11 October 2022 |
| CN | 114492810 | A | 13 May 2022 | CN | 114492810 | B | 24 March 2023 |

Form PCT/ISA/210 (patent family annex) (July 2022)

**EP 4 398 011 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202210713974